# EUROPEAN PATENT APPLICATION

(11) **EP 2 138 610 A1**
(43) Date of publication of application: **30.12.2009**
(21) Application number: 08722473.9
(22) Date of filing: 19.03.2008
(51) Int. Cl.: C30B 29/06, H01L 31/04

(54) **METHOD AND APPARATUS FOR MANUFACTURING SILICON INGOT**

(30) Priority: 19.03.2007 JP 2007069741
(71) Applicant: Mnk-sog Silicon, Inc., Santa Cruz, CA 95060 (US)
(72) Inventor: NISHIO, Kenichi, Takasaki-shi Gunma 370-3334 (JP); KURODA, Teruo, Takasaki-shi Gunma 370-3334 (JP); MORITA, Kazuki, Tokyo 153-8505 (JP)
(74) Representative: Novagraaf IP
(86) International application number: PCT/JP2008/055098
(87) International publication number: WO 2008/114822

(57) **Abstract**

Provided are a novel method and novel apparatus for manufacturing a silicon ingot that make it possible to reduce manufacturing steps and also reduce required electric power.
A method for manufacturing a silicon ingot, including the step of heating and melting, in a crucible, an element which can undergo eutectic reaction with silicon and has a lower eutectic point than the melting point of silicon when made into silicon alloy, and a metallic silicon, thereby generating an alloy melt, and the step of using the eutectic reaction for the alloy melt to subject the silicon to low-temperature solidification refinement, and further producing the silicon ingot from the alloy melt by a pulling method is provided.

## Description

### BACKGROUND OF THE INVENTION

### Field of the Invention

This invention relates to a method and apparatus for manufacturing a silicon ingot suitable for the production of solar cells.

### Description of the Related Art

Nowadays, demand for high-purity silicon has been increasing with a remarkable increase in the production quantity of solar cells. In the production of solar cells, off-specification products of semiconductor silicon, scraps thereof, and others are usually used as raw material. However, in order to cope with an expectable increase in the production quantity of solar cells in the future, required are a manufacturing method and a manufacturing apparatus making it possible to attain mass production of inexpensive silicon for solar cells, which aims for stable supply. Hitherto, in this technical field, methods have been developed for refining inexpensive metallic silicon metallurgically at high temperature in a long time; however, costs therefor have been desired to be made lower.

A method that is one of the metallurgically refining methods and that is for refining silicon for a solar cell (SOG) effectively is suggested in, for example, Japanese Patent No. 3325900.

JP-A No. 2003-286024 suggests a method of putting only a silicon having a higher purity than metallic silicon, as a material, into a crucible, melting this material, and then producing a silicon ingot therefrom by a pulling method.

JP-A No. 2003-277040 suggests a method of raising the purity of a metallic silicon although the document does not refer to any method for producing an ingot.

JP-A No. 2002-047095 suggests a method of doping silicon with aluminum, and then producing a silicon ingot therefrom by a pulling method. In this technique, a eutectic phenomenon is not used.

JP-A No. 10-273313 suggests, as an inexpensive manufacturing method which targets silicon for a solar cell (SOG), a method of solidifying a molten metal in a mold along one direction from the lower region of the metal to the upper region thereof while scanning an electron beam onto the surface of the metal to heat the surface.

### SUMMARY OF THE INVENTION

An object of the present invention is to provide a silicon ingot manufacturing method at low costs that is suitable for the production of a silicon ingot for solar cells, and a manufacturing apparatus used in this method.

According to this invention, a success has been achieved in the production of a silicon polycrystal or silicon monocrystal for solar cells directly from a metallic silicon by a pulling method. The metallic silicon has a purity of about 98% to 99%, so as to have an impurity element. In the invention, a solvent metal which can undergo alloy reaction with silicon is selected, thereby making it possible to attain a crystal-pulling process in a silicon melting temperature set into a remarkably lower temperature range than an ordinary silicon melting temperature, which is 1412°C. Furthermore, the above-mentioned problems have been solved by adding a new function to a CZ type crystal-pulling apparatus for taking out a middle-purity silicon crystal from a molten silicon alloy.

In order to attain the object, the method suggested by this invention, for manufacturing a silicon ingot, is a method including the step of heating and melting, in a crucible, an element which can undergo eutectic reaction with silicon and has a lower eutectic point than the melting point of silicon when made into silicon alloy, and a metallic silicon, thereby generating an alloy melt, and the step of using the eutectic reaction for the alloy melt to subject the silicon to low-temperature solidification refinement, and further producing the silicon ingot from the alloy melt by a pulling method.

It is desired in the method that the liquid temperature of portions of the alloy melt other than the liquid surface thereof is kept into temperatures at which the alloy melt is not solidified, and the liquid surface temperature of the alloy melt is kept into temperatures close to a primary crystallization temperature of the alloy melt which corresponds to the concentration of the silicon in the alloy melt.

It is also desired in the method that the liquid surface temperature of the alloy melt is kept at a temperature that is between the eutectic point and a temperature close to 1273 K and is close to the primary crystallization temperature of the alloy melt which corresponds to the concentration of the silicon in the alloy melt.

As described above, the invention makes it possible to manufacture a silicon ingot directly from a metallic silicon as a raw material. In this way, the manufacturing process can be made simple, and costs therefor can be made low.

The metallic silicon may be a silicon having a purity of 98% or more, which has been hitherto used to manufacture a silicon ingot for solar cells.

In the invention, an element which can undergo eutectic reaction with silicon and has a lower eutectic point than the melting point of silicon when made into silicon alloy, and a metallic silicon are heated and melted in a crucible to generate an alloy melt. This makes it possible to solidify the melt at a temperature lower than the melting point of silicon (1414°C=1687 K), and decrease the power consumption required for the manufacture of silicon ingots. In short, the solidification temperature is changed by the eutectic reaction, thereby lowering the solidification temperature, so that the power consumption can be restrained.

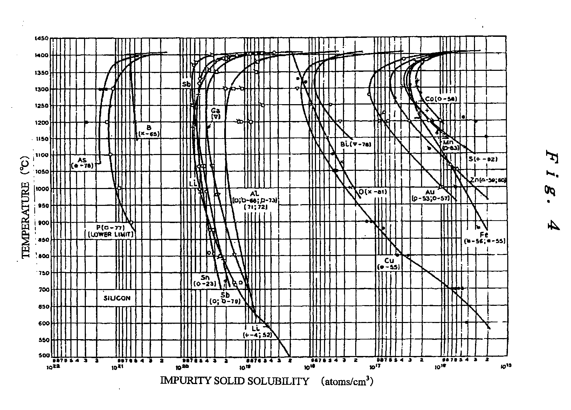

As shown in FIG. 4 (source: F. A. Trumbore, Bell System Technical Journal, 39 (1960), 67.), the solid solubility of an impurity element in silicon exhibits the following unique behavior: the solid solubility increases as the temperature is lowered from the melting point, 1687 K (1414°C), of silicon; and the solid solubility decreases from temperatures in the range of 1473 K (1200°C) to 1273 K (1000°C).

Table 1, which will be described later, shows results of the segregation coefficient of each impurity element in Si-Al melt and solid silicon, the results being obtained from an experiment wherein aluminum is used as an element which can undergo eutectic reaction with silicon and has a lower eutectic point than the melting point of silicon when made into silicon alloy. The segregation coefficient denotes "the ratio of the impurity concentration in the liquid phase to that in the solid phase". The source thereof is as follows: ISIJ International, Vol. 45 (2005), No. 7, pp. 967-971 Refining of Si by the Solidification of Si-Al Melt with Electromagnetic Force. As the segregation coefficient is smaller, the impurity in the solidified silicon is discharged into the side of the liquid phase, which is a solvent, so that a solid silicon having a higher purity can be obtained.

As shown in Table 1, the segregation coefficient is varied in accordance with the primary crystallization temperature of silicon. Therefore, when the melt is solidified in an environment giving an optimal primary crystallization temperature, a high-purity solid silicon can be produced through refinement.

As will be described later, the primary crystallization temperature of the melt and the silicon concentration in the melt have a corresponding relationship. Thus, when the silicon concentration is adjusted, a high-purity solid silicon can be produced through refinement.

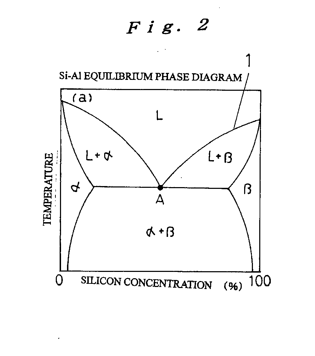

When, for example, aluminum is used as an element which can undergo eutectic reaction with silicon and has a lower eutectic point than the melting point of silicon when made into silicon alloy, the phase diagram of Si-Al eutectic alloy is shown in FIG. 2. In FIG. 2, L represents the liquid phase; β, the solid phase of silicon; α, the solid phase of aluminum; and A, the eutectic point (850 K=577°C). Reference number 1 represents the primary crystallization curve. The primary crystallization curve 1, which represents the primary crystallization temperature of the melt, and the silicon concentration in the melt have a corresponding relationship.

When Si is solidified from a Si-Al alloy melt to the crystal side along the β phase (Al is solid-dissolved in Si) liquidus line, it is necessary to make the concentration in the Si-Al alloy constant. By controlling the Si concentration and the Al concentration in the Si-Al alloy melt, the precipitation temperature of Si is decided.

Thus, about the alloy used in the invention, which is composed of an element which can undergo eutectic reaction with silicon and has a lower eutectic point than the melting point of silicon when made into silicon alloy, and a metallic silicon, a phase diagram as shown in FIG. 2 is prepared beforehand.

In the process for carrying out the manufacturing method of the invention, the silicon concentration in the melt is measured while the surface of the melt is kept in a supercooled liquid state. In other words, the liquid surface temperature of the melt is kept into temperatures close to a primary crystallization temperature of the melt (for example, the primary crystallization curve temperature represented by reference number 1 in FIG. 2) which corresponds to the measured silicon concentration in the melt, for example, at a temperature close to and below the line. Naturally, it is necessary to keep the liquid temperature of the melt portion other than the surface of the melt into temperatures at which the melt is not solidified.

As described above, in the method of the invention, by a pulling method, a seed crystal immersed beforehand into the liquid surface is pulled up from the melt surface that is in the middle of a transition from the supercooled liquid phase to solid phase. In this way, the silicon crystal is grown. At this time, by the property that the segregation coefficient of silicon is small, the impurities are discharged into the solvent liquid phase so that a high-purity silicon crystal grows around the seed crystal. Thus, a silicon ingot can be obtained.

When an attempt is made for crystallizing a melt in a crucible without pulling up any crystal in the prior art, the melt is not turned into an ingot state, thereby causing a problem that a needle crystal is generated so as to be scattered (with reference to "ISIJ International, Vol. 45 (2005), No. 7, pp. 967-971 Refining of Si by the Solidification of Si-Al Melt with Electromagnetic Force"). The invention has solved this problem by a pulling method, and succeeded in making a melt intc an ingot.

For the method for manufacturing a silicon ingot according to the invention, it is important what (value) is the silicon concentration in the alloy melt, that is, the ratio of an element which can undergo eutectic reaction with silicon and has a lower eutectic point than the melting point of silicon when made into silicon alloy, and a metallic silicon, both of which are to be put into a crucible.

Firstly, it is more preferred from the viewpoint of electric power saving that the silicon concentration is lower since the melting point of silicon becomes lower with a decrease in the concentration thereof.

Secondly, in connection with an increase in the purity, there is a unique behavior that as the temperature is lowered than temperatures close to 1273 K (1000°C), the solid solubility of the impurity elements is decreased. When the alloy melt is solidified, a larger amount of the impurities is discharged into the solvent liquid phase.

Thirdly, when the solidification of the silicon is advanced by the pulling method, the silicon concentration in the alloy melt is naturally lowered, so that the concentration falls below a silicon concentration corresponding to the eutectic point. In this case, no silicon crystal can be taken out.

In light of the first and second points, it is desired to charge, into a crucible, an element which can undergo eutectic reaction with silicon and have a lower eutectic point than the melting point of silicon when made into silicon alloy, and a metallic silicon at such a ratio that the silicon concentration is made as low as possible. However, according to the third point, the amount of the crystal that can be taken out becomes small when the silicon concentration is originally low.

In light of the above-mentioned matters, it is desired to charge, into a crucible, an element which can undergo eutectic reaction with silicon and has a lower eutectic point than the melting point of silicon when made into silicon alloy, and a metallic silicon at such a ratio that the silicon concentration gives a melting point at a temperature close to 1273 K (1000°C).

In the silicon ingot manufacturing method of the invention, for example, aluminum or copper may be used as the element, which can undergo eutectic reaction with silicon and has a lower eutectic point than the melting point of silicon when made into silicon alloy.

In the silicon ingot manufacturing method of the invention, the step of generating the alloy melt and the step of producing the silicon ingot are performed in the atmosphere of an inert gas, for example, the atmosphere of argon gas.

This manner makes it possible to prevent the oxidation of the silicon and further prevent the oxidation of the element, which can undergo eutectic reaction with silicon and has a lower eutectic point than the melting point of silicon when made into silicon alloy, for example, aluminum, so that a decline in the efficiency of absorbing the impurities can be prevented. This makes it possible to manufacture a high-purity silicon ingot which has a higher purity and is more suitable for being used for solar cells.

For the same reason, the crucible can be a crucible made not of quartz, which is ordinarily used, but of silicon nitride.

In order to attain the object, the apparatus for manufacturing a silicon ingot that is next suggested by this invention is an apparatus used in the method for manufacturing the silicon ingot of the invention and provided with a container to which a vacuum exhaust system and a gas introducing system are connected, a crucible set in the container, a heating means for heating the crucible to generate an alloy melt in the crucible, a pulling-up means for making a silicon crystal in an ingot form, and a liquid surface temperature measuring means for measuring the liquid surface temperature of the alloy melt in the crucible.

The heating means has a function of heating the region of the liquid surface of the alloy melt generated in the crucible, and other region of the alloy melt at intensities independent of each other.

The apparatus of the invention for manufacturing a silicon ingot has a controlling means for grasping the amount of a fall in the concentration of silicon in the alloy melt, and further controlling the heating based on the heating means to keep the liquid surface temperature of the alloy melt into temperatures close to a primary crystallization temperature which corresponds to the grasped silicon concentration in the alloy melt.

As described above, in the apparatus of the invention for manufacturing a silicon ingot, the following are connected to a container in which a crucible is set: a vacuum exhaust system; and a gas introducing system (a gas introducing system for introducing an inert gas, such as argon gas, into the container). This manner makes it possible to prevent the oxidation of silicon, and further prevent the oxidation of an element which can undergo eutectic reaction with silicon and has a lower eutectic point than the melting point of silicon when made into silicon alloy, for example, aluminum, so that a decline in the efficiency of absorbing impurities can be prevented.

The heating means is capable of: making a metallic silicon and an element which can undergo eutectic reaction with silicon and has a lower eutectic point than the melting point of silicon when made into silicon alloy, for example, aluminum, both of which are charged into the crucible, into an alloy melt; and further conducting a liquid temperature control described below. The liquid temperature control is a function of heating the two regions, the liquid surface of the alloy melt in the crucible, and the other region of the alloy melt at intensities independent of each other. The liquid temperature control through the heating means is carried out by manual operation, and/or automatic operation based on programming.

In the controlling means, the function of grasping the amount of a fall in the silicon concentration in the alloy melt is a function of calculating out the fall amount of the silicon concentration in the melt, for example, based on the weight of the silicon ingot pulled up by the pulling-up means, which will be described later.

The function of controlling the heating based on the heating means in the controlling means in such a manner that the liquid surface temperature of the alloy melt is kept into temperatures close to a primary crystallization temperature which corresponds to the grasped silicon concentration in the alloy melt is a function of outputting a command for heating the crucible with reference to the following: the liquid surface temperature of the alloy melt in the crucible, the temperature being measured by the liquid surface temperature measuring means; and the fall amount of the silicon concentration in the alloy melt, which has been grasped as described above. In accordance with this output, the heating based on the heating means is controlled so as to keep the liquid surface temperature of the alloy melt in the crucible into temperatures close to the primary crystallization temperature corresponding to the grasped silicon concentration in the alloy melt, that is, so as to keep the liquid surface into a supercooled liquid state and further keep the melt portion other than the liquid surface in a liquid phase.

About the alloy melt that can undergo eutectic reaction, the primary crystallization temperature thereof is also varied in accordance with a change in the concentration of the melt. In the invention, the silicon concentration in the melt is decreased by the precipitation of silicon crystal; therefore, it is required to measure the silicon concentration in the melt.

In the controlling device, a silicon primary crystallization temperature corresponding to any silicon concentration is stored. When the device receives information on the present silicon concentration and the present liquid surface temperature, the device can output, to the heating means, a heating command for keeping the present supercooled liquid state of the melt surface.

The pulling-up means in the silicon ingot manufacturing apparatus of the invention is generally the means adopted when a monocrystal silicon ingot in a semiconductor grade is manufactured from polycrystal silicon as a raw material.

In the invention, the pulling-up means, which is known in the prior art, is used to make silicon crystal into an ingot form. By immersing a seed crystal into the liquid surface of the alloy melt, rotating the crystal, and then making a pulling-up operation slowly, a silicon crystal solidified around the seed crystal is grown.

In other words, the pulling-up means in the silicon ingot manufacturing apparatus of the invention is a means which exhibits a function of keeping the liquid surface into a supercooled liquid state through the heating means and the controlling means, and further making the liquid surface of the alloy melt, the liquid phase of which is kept in the melt portion other than the liquid surface, into an ingot form. Advantageous effects

According to this invention, provided can be a method for manufacturing a silicon ingot at low costs wherein a metallic silicon is used as a raw material to manufacture the silicon ingot directly, the method being suitable for manufacturing a silicon ingot for solar cells; and a manufacturing apparatus used in this method.

By heating and melting, in a crucible, an element which can undergo eutectic reaction with silicon and has a lower eutectic point than the melting point of silicon when made into silicon alloy, and a metallic silicon, an alloy melt is generated, thereby making it possible to solidify the melt at a lower temperature than the melting point of silicon (1414°C=1687 K), and decrease power consumption required for manufacturing a silicon ingot.

### BRIEF DESCRIPTION OF THE DRAWINGS

FIG. 1 is a view referred to in order to describe a general structure of a silicon ingot manufacturing apparatus of this invention;
FIG. 2 is a phase diagram of Si-Al eutectic alloy;
FIG. 3 is an enlarged view of a portion of the phase diagram of Si-Al eutectic alloy;
FIG. 4 is a graph showing the solid solubility of each impurity element in silicon;
FIG. 5 is a view illustrating an example of a specific structure of another silicon ingot manufacturing apparatus of this invention; and

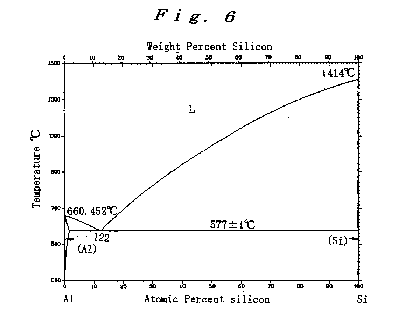

FIG. 6 is a graph showing the state of the concentration of Si and that of Al that correspond to a temperature change.

### DESCRIPTION OF THE PREFERRED EMBODIMENT

With reference to the attached drawings, preferred embodiments of the invention will be described hereinafter.

### Example 1

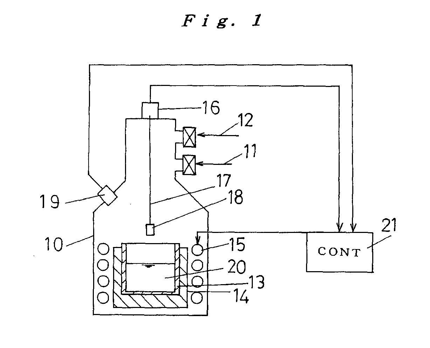

FIG. 1 is a view illustrating a general structure of a silicon ingot manufacturing apparatus of the invention, wherein a manufacturing method of the invention is carried out.

A vacuum exhaust system 11 and a gas introducing system 12 are connected to a container 10.

A crucible 13 made of silicon nitride is set at the center on the bottom of the container 10 in the state that the crucible 13 is held in a graphite crucible 14. A heater 15 is located on the outside of the graphite crucible 14, so that a material charged in the crucible 13 can be heated.

A pulling-up mechanism 16 having a weight-measuring function is set on the top of the container 10. From this pulling-up mechanism 16 toward the crucible 13, a freely-rotatable axis 17 is extended.

A seed crystal 18 may be fitted to the bottom end of the axis 17.

In a side wall of the container 10 a two-wavelength type radiation thermometer 19 is set, so that the surface temperature of a melt 20, which is heated and melted in the crucible 13, can be measured.

The heater 15 is connected to a controlling device 21 set in the outside of the container 10.

The controlling device 21 can gain information on the weight of a silicon ingot pulled up from the pulling-up mechanism 16, which has a weight-measuring function, by an intermediary aid of the seed crystal 18 and information on the surface temperature of the melt 20, which is measured by means of the two-wavelength type radiation thermometer 19.

The heater 15 is formed to make, into an alloy melt, a metallic silicon and an element which can undergo eutectic reaction with silicon and has a lower eutectic point than the melting point of silicon when made into silicon alloy, for example, aluminum, the metallic silicon and the element being charged in the crucible 13, and further formed to receive a control based on the controlling device 21 to heat the alloy melt at intensities independent of each other in two regions that are the liquid surface of the alloy melt in the crucible 13 and other melt region.

Specifically, the controlling device 21 calculates out the amount of a fall in the silicon concentration in the melt 20 in the crucible 13 from the weight of the silicon ingot pulled up by the pulling-up mechanism 16, which has a weight-measuring function; decides the electric power to be supplied to the heater 15 in such a manner that the liquid surface temperature of the melt 20 is kept into temperatures close to a primary crystallization temperature corresponding to the calculated silicon concentration in the melt 20, preferably at a temperature below and close to the primary crystallization temperature, and further the melt portion other than the liquid surface is kept in the liquid phase; and controls the heating based on the heater 15.

The manufacturing apparatus constructed as described above is used to manufacture a silicon ingot by the method of the invention, general information of which will be described hereinafter.

First, a metallic silicon and aluminum are charged into the crucible 13 set in the container 10.

The purity of the metallic silicon is set to 98% or more.

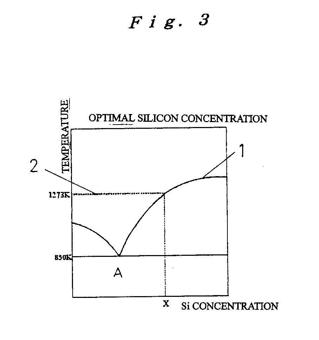

With reference to the phase diagram of Si-Al eutectic alloy shown in FIGs. 2 and 3, the ratio by weight between the metallic silicon and aluminum to be charged are adjusted to set the silicon concentration to X (in FIG. 3) at a point close to 1273 K (1000°C).

After the metallic silicon and aluminum are charged into the crucible 13, the gas in the container 10 is discharged through the vacuum exhaust system 11 while a high-purity inert gas (argon gas) is introduced into the container 10 through the gas introducing system 12.

A purpose thereof is to remove oxygen in the container 10, thereby preventing the oxidation of the silicon, and further prevent a fall in the impurity-absorbing efficiency by the oxidation of aluminum. The vacuum exhaust and the introduction of the inert gas are continuously conducted during a crucible-heating and a silicon-ingot-pulling that will be described below.

After oxygen in the container 10 is removed as described above, electric power is supplied to the heater 15 through the controlling device 21 to heat the inside of the crucible 13, thereby melting the charged metallic silicon and aluminum to generate a Si-Al eutectic alloy melt.

Through the two-wavelength type radiation thermometer 19, the temperature of the liquid surface of the melt 20 is monitored and the temperature is controlled, so as to keep the liquid surface temperature at the primary crystallization temperature and continue to control the heating until the metallic silicon and aluminum charged into the crucible 13 are completely melted.

After the material in the crucible 13 is completely melted, the axis 17 extended from the pulling-up mechanism 16 is lowered to immerse the seed crystal 18 into the Si-Al melt and then rotate the seed crystal 18 slowly.

Next, the pulling-up mechanism 16 is used to pull up the seed crystal 18 slowly to grow the silicon crystal by an intermediary aid of the seed crystal 18.

By the pulling-up of the silicon ingot, the silicon concentration in the Si-Al melt 20 falls; however, the controlling device 21 calculates the silicon concentration and further controls the electric power to be supplied to the heater 15, using, as a target value at any time, a temperature close to (and slightly below) a primary crystallization curve 1 corresponding to the calculated Si concentration in the Si-Al melt 20 in such a manner that the surface temperature of the Si-Al melt 20 is kept into temperatures close to a primary crystallization temperature corresponding to the calculated Si concentration in the Si-Al melt 20 so as to keep the surface temperature of the Si-Al melt 20 in a supercooled liquid state.

The segregation coefficient of each of the impurity element in the Si-Al melt and the solid silicon (silicon crystal) was obtained in an experiment. The results in Table 1 were obtained. From the results, it was verified that when silicon was solidified from the Si-Al melt, the impurities were discharged to the side of the melt.

### [Table 1]

### Impurity

### Example 2

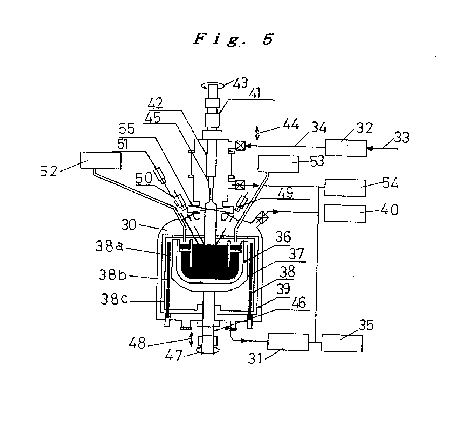

FIG. 5 is a view illustrating an example of a specific structure of another silicon ingot manufacturing apparatus of the invention, wherein a manufacturing method of the invention is carried out.

A vacuum exhaust device 31 and an Ar gas introducing device 32 are connected to a vacuum chamber 30 constituting a crystal growing furnace. As represented by an arrow 33, a high-purity Ar gas (99.9999%) is supplied to the Ar gas introducing device 32. A superhigh-purity Ar gas, the purity of which has been made high in the Ar gas introducing device 32, is supplied from above the vacuum chamber 30 into the vacuum chamber 30, as represented by an arrow 34.

The vacuum exhaust device 31 is composed of, for example, a rotary pump and a turbo molecular pump.

Under a control of a controller 40, high-vacuum exhaust is conducted by the vacuum exhaust device 31, so that the achieved vacuum in the vacuum chamber 30 will turn to about 10⁻³ Pa (at room temperature), for example.

An exhaust gas removing device 35 can be connected to the vacuum exhaust device 31 at the downstream side thereof. When a silicon crystal grows in the vacuum chamber 30, silicon oxide, additive oxides, nitrogen monoxide and others are discharged. The exhaust gas removing device 35 takes charge of making these gases nonpoisonous and then discharging the gases into the atmosphere.

An inner crucible 36 made of silicon nitride is set at the center on the bottom of the vacuum chamber 30 in the state that the inner crucible 36 is held in an outer crucible 37 made of graphite. A heater 38 is located on the outside of the outer crucible 37, so that a material charged in the inner crucible 36 can be heated.
The periphery of the heater 38 is covered with a heat shield 39.

The heater 38 is composed of an upper heater 38a for heating the upper side of the outer crucible 37, a middle heater 38b for heating the lower side of the outer crucible 37, and a lower heater 38c for heating the outer crucible 37 from the bottom side thereof.

The upper heater 38a, the middle heater 38b and the lower heater 38c are controlled independently of each other by the controller 40.

This manner is used to make, into an alloy melt, a metallic silicon and an element which can undergo eutectic reaction with silicon and has a lower eutectic point than the melting point of silicon when made into silicon alloy, for example, aluminum, the metallic silicon and the element being charged in the inner crucible 36, and further to receive a control based on the controller 40 to heat the alloy melt at intensities independent of each other in two regions that are the liquid surface of the alloy melt in the inner crucible 36 and the other melt region.

A pulling-up axis load cell 41 is arranged above the vacuum chamber 30 to interpose a gate valve 55 therebetween. From the pulling-up axis load cell 41 toward the inner crucible 36, a freely-rotatable pulling-up shaft 42 is extended. The pulling-up shaft 42 can be rotated in a direction represented by an arrow 43 and in the direction reverse thereto, and can further be raised and lowered as represented by an arrow 44 under a control of the controller 40.

A seed chuck 45, which has a tip (at the bottom end side in FIG. 5) to which a seed crystal is to be fitted, is arranged at the bottom end of the pulling-up shaft 42.

In the state that the seed chuck 45 grasps a seed crystal, the pulling-up shaft 42 is lowered so that the seed crystal arrives at the melt in the inner crucible 36. Thereafter, the pulling-up shaft 42 is raised to pull up a silicon crystal. At this time, an increase per unit time in the weight of the silicon crystal is detected through the pulling-up axis load cell 41. Information on the detected increase per unit time in the weight of the silicon crystal is sent to the controller 40, and then used for a control of the apparatus by the controller 40.

With reference to, for example, the increase per unit time in the weight of the silicon crystal, the increase being detected through the pulling-up axis load cell 41, the controller 40 calculates out the amount of a fall in the silicon concentration in the Si-Al alloy melt in the inner crucible 36; decides the electric power to be supplied to the heater 38 (the upper heater 38a, the middle heater 38b, and the lower heater 38c) in such a manner that the liquid surface temperature of the melt is kept in temperatures close to a primary crystallization temperature corresponding to the calculated silicon concentration in the melt, preferably at a temperature below and close to the primary crystallization temperature, and further the melt portion other than the liquid surface is kept in the liquid phase; and controls the heating based on the heater 38.

The bottom end of the outer crucible 37 is supported by a crucible axis load cell 46. The outer crucible 37 is supported by the crucible axis load cell 46, and the crucible axis load cell 46 is controlled by the controller 40, whereby the load cell 46 can be rotated in a direction represented by an arrow 47 or in the direction reverse thereto, and further can be raised and lowered as represented by an arrow 48. Following the rotating, the raising and the lowering of the outer crucible 37, the inner crucible 36 is also rotated, raised and lowered together with the outer crucible 37.

In the vacuum chamber 30, an optical pyrometer 49 and a color CCD camera 50 are arranged. The surface temperature of the melt in the inner crucible 36, the temperature being grasped by the optical pyrometer 49, is sent to the controller 40. Information on images photographed by the color CCD camera 50 is sent to the controller 40 to monitor the arrival of the seed crystal in the melt, the formation of a shoulder region, the growth of a body region, and other states.

A laser liquid level meter 51 is also arranged in the vacuum chamber 30, so that the surface level of the melt in the inner crucible 36 is measured. Information thereon is sent to the controller 40.

Furthermore, a metallic silicon filling device 52, and an additive material filling device 53 are arranged in the vacuum chamber 30.

The metallic silicon filling device 52 fills a metallic silicon automatically into the inner crucible 36 through a control of the controller 40 based on the information on the increase per unit time in the weight of the silicon crystal, the increase being detected by the pulling-up axis load cell 41. In other words, a portion of the metallic silicon that corresponds to the detected weight increase is weighed and the weighed portion is automatically filled in the inner crucible 36.

When Si is solidified into the crystal side from the Si-Al alloy melt in the inner crucible 36, Si in the Si-Al alloy melt is decreased so that the Si concentration in the Si-Al alloy melt falls. When the Si concentration falls, the solidification temperature changes into a lower temperature. As a result, the temperature of the solid-liquid interface between the Si crystal and the Si-Al alloy melt becomes unable to be controlled so that a stable growth of a Si crystal is hindered.

Thus, a change per unit time in the mass of the pulled-up Si crystal is detected by the pulling-up axis load cell 41. Moreover, the crucible axis load cell 46 detects the mass of the Si-Al alloy melt and monitors the mass so as to set a change in the mass into a specified range constantly.

The mass change per unit time detected by the pulling-up axis load cell 41 is an increase based on the growth of the Si crystal; therefore, the metallic silicon that corresponds to the mass change detected by the pulling-up axis load cell 41 is supplied from the outside of the vacuum camber 30 to the inner crucible 36. The supplied metallic silicon is melted to diffuse into the Si-Al alloy melt.

Under a control of the controller 40, the additive material filling device 53 fills an appropriate amount of Al or Ti automatically into the inner crucible 36.

In a case where Al is evaporated dependently on the process temperature while the crystal grows, the Al concentration in the Si-Al alloy melt falls. In light of the evaporation profile of Al in the process, under a control of the controller 40, Al is filled into the inner crucible 36 at appropriate times by the additive material filling device 53.

By controlling the Al concentration in the Si-Al alloy melt, the P concentration in the Si crystal can be remarkably decreased.

Since P has a large segregation coefficient, P cannot be removed through an ordinary solidifying process. However, the Al concentration in the Si-Al alloy melt is increased so that Al and P are caused to react with each other to turn to AlP, which precipitates in a low temperature range wherein AlP precipitates in the liquid phase.

Thus, under a control of the controller 40, Al is filled into the inner crucible 36 at appropriate times by the additive material filling device 53, so that the P concentration in the Si crystal can be remarkably decreased.

Moreover, under a control of the controller 40, Ti is filled into the inner crucible 36 at appropriate times by the additive material filling device 53, so that the B concentration in the Si crystal can be remarkably decreased.

Since B has a large segregation coefficient in the same manner as P, B cannot be removed through an ordinary solidifying process. However, an appropriate amount of Ti is added into the Si-Al alloy melt, so that Ti and B are caused to react with each other to turn to TiB, which precipitates in a low temperature range wherein TiB precipitates in the liquid phase.

Thus, under a control of the controller 40, Ti is filled into the inner crucible 36 at appropriate times by the additive material filling device 53, so that the B concentration in the Si crystal can be remarkably decreased.

A process for manufacturing a silicon ingot by the method of the invention using this manufacturing apparatus of Example 2 is the same as those described in Example 1. Thus, description thereof is omitted.

The above has described some of preferred embodiments of the invention with reference to the drawings; however, the invention is not limited to the embodiments. The embodiments may be changed into various forms within the technical scope grasped from the recitation of the claims.

## Claims

1. A method for manufacturing a silicon ingot, comprising:
a step of heating and melting, in a crucible, an element which can undergo eutectic reaction with silicon and has a lower eutectic point than the melting point of silicon when made into silicon alloy, and a metallic silicon, thereby generating an alloy melt, and
a step of using the eutectic reaction for the alloy melt to subject the silicon to low-temperature solidification refinement, and further producing the silicon ingot from the alloy melt by a pulling method.

2. The method for manufacturing a silicon ingot according to claim 1, wherein the liquid temperature of portions of the alloy melt other than the liquid surface thereof is kept into temperatures at which the alloy melt is not solidified, and
the liquid surface temperature of the alloy melt is kept into temperatures close to a primary crystallization temperature of the alloy melt which corresponds to the concentration of the silicon in the alloy melt.

3. The method for manufacturing a silicon ingot according to claim 2, wherein the liquid surface temperature of the alloy melt is kept at a temperature that is between the eutectic point and a temperature close to 1273 K and is close to the primary crystallization temperature of the alloy melt which corresponds to the concentration of the silicon in the alloy melt.

4. The method for manufacturing a silicon ingot according to any one of claims 1 to 3, wherein the element is aluminum.

5. The method for manufacturing a silicon ingot according to any one of claims 1 to 4, wherein the step of generating the alloy melt and the step of producing the silicon ingot are performed in the atmosphere of argon gas.

6. The method for manufacturing a silicon ingot according to any one of claims 1 to 5, wherein the crucible is made of silicon nitride.

7. An apparatus for manufacturing a silicon ingot, comprising:
a container to which a vacuum exhaust system and a gas introducing system are connected,
a crucible set in the container,
a heating means for heating the crucible to generate an alloy melt in the crucible,
a pulling-up means for making a silicon crystal in an ingot form, and
a liquid surface temperature measuring means for measuring the liquid surface temperature of the alloy melt in the crucible,
the heating means having a function of heating the region of the liquid surface of the alloy melt generated in the crucible, and other region of the alloy melt at intensities independent of each other, and
the apparatus having a controlling means for grasping the amount of a fall in the concentration of silicon in the alloy melt, and further controlling the heating based on the heating means to keep the liquid surface temperature of the alloy melt into temperatures close to a primary crystallization temperature which corresponds to the grasped silicon concentration in the alloy melt.

8. The apparatus for manufacturing a silicon ingot according to claim 7, wherein the gas introducing system is a system for introducing argon gas into the container.

9. The apparatus for manufacturing a silicon ingot according to claim 7 or 8, wherein the crucible is made of silicon nitride.
